Europäisches Patentamt

European Patent Office

Office européen des brevets

(19)

(11) **EP 1 505 738 A1**

(12) **EUROPEAN PATENT APPLICATION**
published in accordance with Art. 158(3) EPC

(43) Date of publication:
**09.02.2005 Bulletin 2005/06**

(51) Int Cl.7: **H04B 1/04**, H03F 1/32

(21) Application number: **02738758.8**

(86) International application number:
**PCT/JP2002/006085**

(22) Date of filing: **19.06.2002**

(87) International publication number:
**WO 2004/001989 (31.12.2003 Gazette 2004/01)**

(84) Designated Contracting States:
**AT BE CH CY DE DK ES FI FR GB GR IE IT LI LU MC NL PT SE TR**

(71) Applicant: **FUJITSU LIMITED**
**Kawasaki-shi, Kanagawa 211-8588 (JP)**

(72) Inventor: **SUZUKI, Masayoshi, c/o Fujitsu Ltd.**
**Kawasaki-shi, Kanagawa 211-8588 (JP)**

(74) Representative: **Hitching, Peter Matthew et al**
**Haseltine Lake,**
**Imperial House,**
**15-19 Kingsway**
**London WC2B 6UD (GB)**

(54) **TRANSMITTER**

(57)     Disclosed is a transmitting apparatus having a distortion compensator that corrects distortion of an amplifier. In this transmitting apparatus, a first frequency converter mixes local oscillation signals with a distortion-compensated transmit signal to thereby up-convert transmit-signal frequency to a radio frequency and input the resultant signal to the amplifier; a second frequency converter mixes local oscillation signals with an output signal of the amplifier to thereby down-convert a radio frequency to a prescribed frequency; and a local oscillation signal generator generates various local oscillation signals, synchronizes the phases of local oscillation signals of a high frequency used by the first and second frequency converters and makes the phase noise components thereof identical.

*FIG. 1*

## Description

Technical Field

This invention relates to a transmitting apparatus having a distortion compensator for correcting the distortion of an amplifier. More particularly, the invention relates to a transmitting apparatus capable of reducing leakage of power between adjacent channels by eliminating the adverse effects of phase noise of a local oscillation signal used in frequency conversion.

Background Art

In wireless communications in recent years, there is growing use of high-efficiency transmission using digital techniques. In instances where multilevel phase modulation is applied to wireless communications, a vital technique is one which can suppress non-linear distortion by linearizing the amplification characteristic of the power amplifier on the transmitting side and reduce the leakage of power between adjacent channels. A technique which compensates for the occurrence of distortion that arises when an attempt is made to improve power efficiency by using an amplifier that exhibits poor linearity is essential.

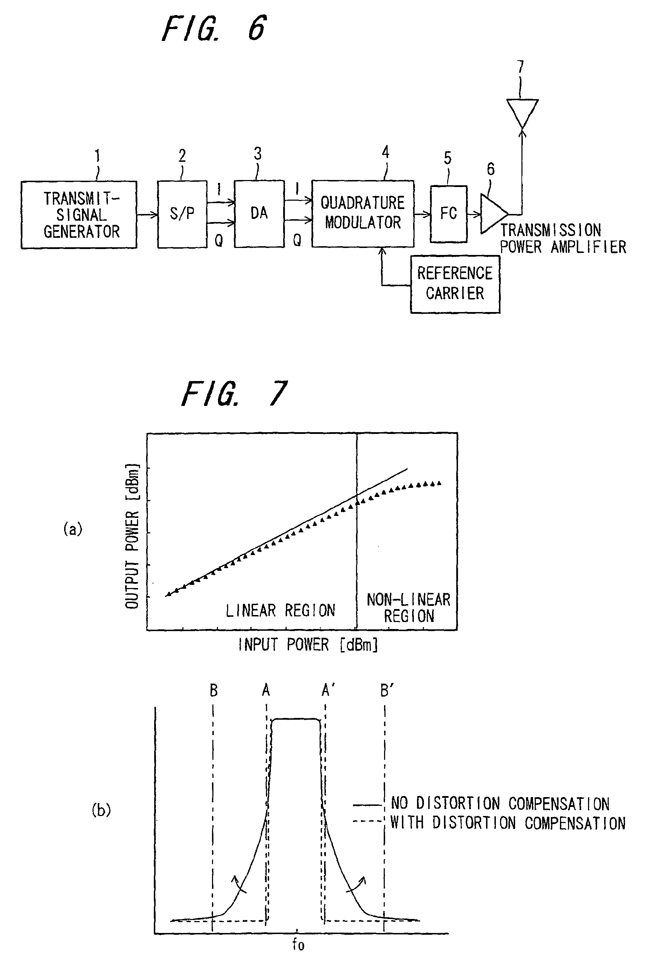

Fig. 6 is a block diagram illustrating an example of a transmitting apparatus in a radio according to the prior art. Here a transmit-signal generator 1 transmits a serial digital data string and a serial/parallel converter (S/P converter) converter 2 splits the digital data string alternately one bit at a time to convert the data to two sequences, namely an in-phase component signal (I signal: In-phase component) and a quadrature component signal (Q signal: Quadrature-phase component). A DA converter 3 converts the I and Q signals to respective analog baseband signals and inputs these to a quadrature modulator 4. The latter multiplies the input I and Q signals (the transmit baseband signals) by a reference carrier wave and a signal that has been phase-shifted relative to the reference carrier by 90°, respectively, and adds the results of mixing to thereby perform quadrature modulation and output the modulated signal. A frequency converter 5 mixes the quadrature-modulated signal and a local oscillation signal to thereby effect a frequency conversion, and a transmission power amplifier 6 power-amplifies the carrier output from the frequency converter 5. The amplified signal is released into space from an antenna 7.

In mobile communications based upon W-CDMA, etc., the transmission power of the transmitting apparatus is a high ten watts to several tens of watts, and the input/output characteristic [distortion function f(p)] of the transmission power amplifier 6 is non-linear, as indicated by the dotted line in (a) of Fig. 7. Nonlinear distortion arises as a result of this non-linear characteristic, and the frequency spectrum in the vicinity of a transmission frequency $f_0$ comes to exhibit a characteristic having side lobes, as indicated by the solid line in (b) of Fig. 7, leakage into adjacent channels occurs and this causes interference between adjacent channels. More specifically, owing to non-linear distortion, there is an increase in power that causes transmitted waves to leak into the adjacent frequency channels, as indicated at (b) in Fig. 7. Such leakage power constitutes noise in other channels and degrades the quality of communication of these channels. Such leakage must be limited to the utmost degree.

For example, leakage power is small in the linear region [see (a) in Fig. 7] of a power amplifier and large in the non-linear region. Accordingly, it is necessary to broaden the linear region in order to obtain a transmission power amplifier having a high output. However, this necessitates an amplifier having a performance higher than that actually needed and therefore a problem which arises is inconvenience in terms of cost and apparatus size. Accordingly, a transmitting apparatus that has come to be adopted is equipped with a distortion compensating function that compensates for distortion ascribable to non-linearity of the power amplifier.

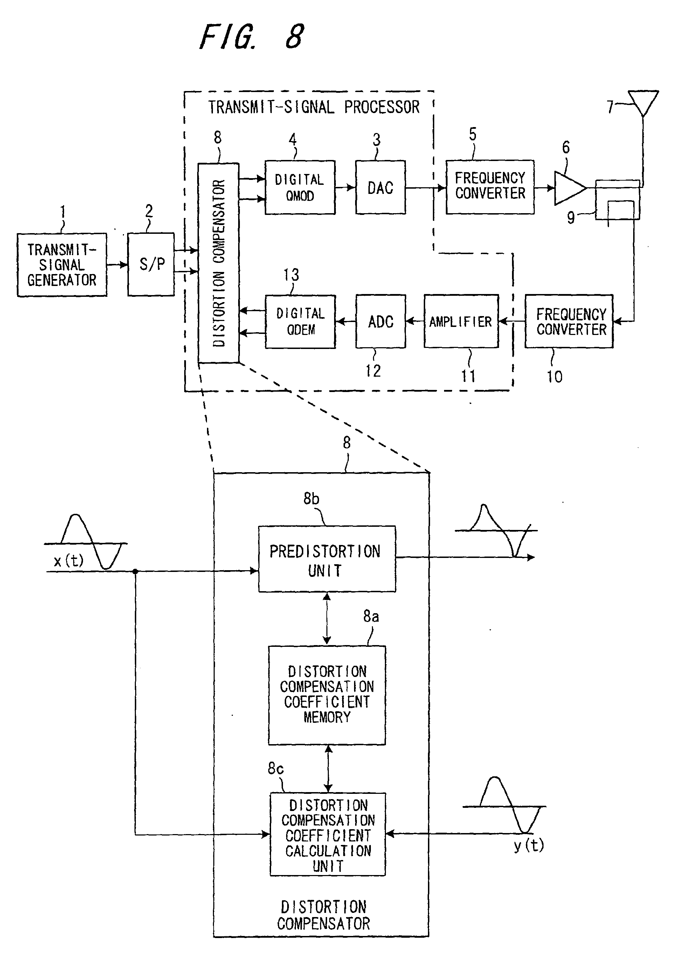

Fig. 8 is a block diagram of a transmitting apparatus having a digital non-linear distortion compensating function that employs a DSP (Digital Signal Processor). Here a group of digital data (a transmit signal) sent from the transmit-signal generator 1 is converted to two signal sequences, namely I and Q signals, in the S/P converter 2, and these signals enter a distortion compensator 8 constituted by a DSP. The distortion compensator 8 includes a distortion compensation coefficient memory 8a for storing distortion compensation coefficients h(pi) (i = 0 ~ 1023) conforming to power levels 0 ~ 1023 of the transmit signal x(t); a predistortion unit 8b for subjecting the transmit signal to distortion compensation processing (predistortion) using a distortion compensation coefficient h(pi) that is in conformity with the level of the transmit signal; and a distortion compensation coefficient calculation unit 8c for comparing the source terminal with a demodulated signal (feedback signal), which has been obtained by demodulation in a quadrature detector described later, and for calculating and updating the distortion compensation coefficient h(pi) in such a manner that the difference between the compared signals will approach zero. The principle of the distortion compensator 8 is that in order to compensate for distortion in the power amplifier 6, a distortion compensating component that is the inverse of this distortion is applied in front of the power amplifier so that this distortion compensating component will be cancelled by the distortion of the power amplifier, thereby eliminating distortion from the output signal.

The transmit signal of the baseband that has been subjected to predistortion processing by the distortion compensator 8 is input to the quadrature modulator 4. The latter applies quadrature modulation processing to the entered I and Q signals, and the DA converter converts the digital modulated signal that is output from the quadrature modulator to an analog signal. The frequency converter 5 mixes the quadrature-modulated signal (the transmit IF signal) and a local oscillation signal to thereby effect a frequency conversion to a radio signal frequency. The transmission power amplifier 6 power-amplifies the radio signal output from the frequency converter 5. The amplified signal is released into space from the antenna 7.

Part of the transmit signal is input to a frequency converter 10 via a directional coupler 9, whereby the signal undergoes a frequency conversion to an intermediate frequency and then amplification by an amplifier 11. An AD converter 12 converts the amplified I and Q signals to digital data and inputs the digital data to a digital quadrature detector 13. By way of adaptive signal processing using the LMS (Least Mean Square) algorithm, the distortion compensator 8 compares the transmit signal before distortion compensation with the feedback signal demodulated by the digital quadrature detector 13 and proceeds to calculate and update the distortion compensation coefficient h(pi) in such a manner that the difference between the compared signals will become zero. By thenceforth repeating this operation, non-linear distortion of the transmission power amplifier 6 is suppressed to reduce the leakage of power between adjacent channels.

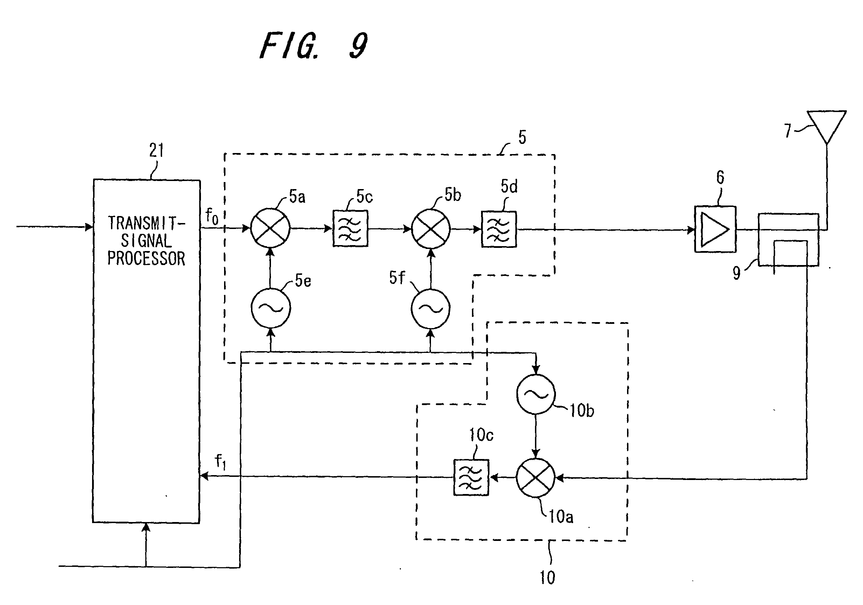

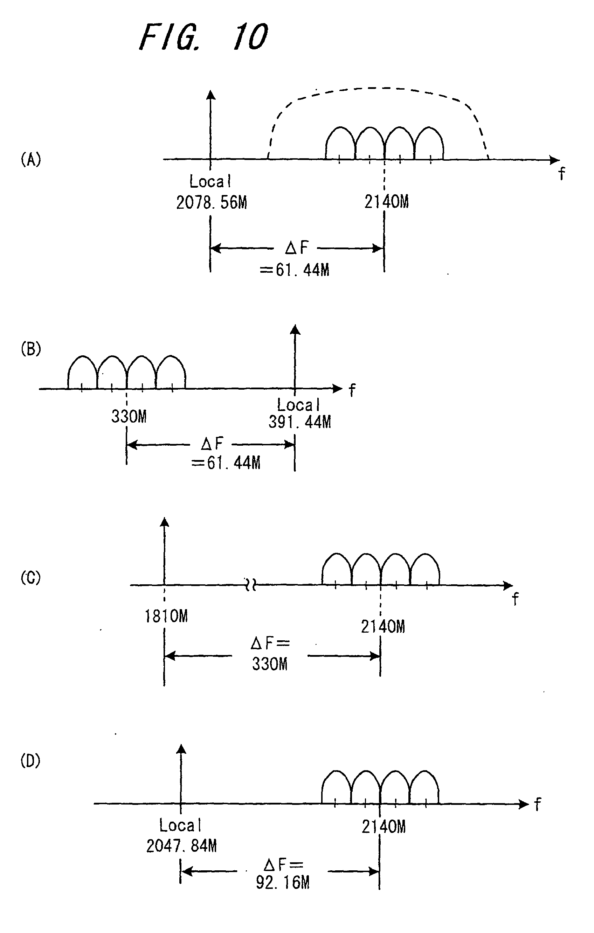

Fig. 9 is a diagram showing the structure of the transmit apparatus that includes the details of structure of the frequency converters 5, 10, in which components identical with those of Fig. 8 are designated by like reference characters. A transmit-signal processor 21 includes the distortion compensator 8, quadrature modulator and demodulators 4 and 13, DA and AD converters 3 and 12 and amplifier 11 of Fig. 8. The frequency converter 5 has a structure in which mixers 5a, 5b are cascade-connected in two stages. The oscillation frequency of a local oscillator 5e that inputs a local oscillation signal to the first mixer 5a is in the 400-MHz band, as shown at (B) in Fig. 10. The mixer 5a mixes this local oscillation signal and an IF signal in the 60-MHz band, and a bandpass filter 5c outputs an IF signal in the center-frequency 300-MHz band by filtering. The oscillation frequency of a second local oscillator 5f is in the 1800-MHz band, as shown at (C) in Fig. 10. The mixer 5b mixes this local oscillation signal and an IF signal in the 300-MHz band, and a bandpass filter 5d passes a radio signal in the center-frequency 2-GHz band by filtering and inputs this radio signal to the power amplifier 6.

A mixer of a single stage is adopted in the frequency converter 10 on the feedback side for the following reason: On the transmitting side, it is necessary that unwanted waves (the local oscillation signal) being stringently eliminated in order to satisfy international standards. Unwanted waves are removed, therefore, by the two-stage connection. On the feedback side, however, there are no restrictions in terms of international standards and if there is no impediment to the distortion compensating operations, then this will suffice. In the frequency converter 10 on the feedback side, therefore, a single-stage structure is adopted for a mixer 10a.

The frequency $f_1$ of the feedback signal that enters the transmit-signal processor 21 is in the 100-MHz band. If the frequency of the feedback signal is low, a deviation develops in the phase - frequency characteristic of the amplifier 11 (see Fig. 8) for the feedback-signal band and the deviation becomes large particularly on the low-frequency side. The phase - frequency deviation causes a decline in the calculation accuracy of the distortion compensator 8. Accordingly, it is required that the frequency of the feedback signal be made a frequency so high that a phase - frequency deviation will not occur in the amplifier 11 for the feedback-signal band. However, the 100-MHz band is the limit in terms of the capability of the AD converter 12 at the present time.

Consequently, the oscillation frequency of a local oscillator 10b is in the vicinity of the 2-GHz band, as indicated at (D) in Fig. 10. The mixer 10a mixes this local oscillation signal and the radio signal of the 2-GHz band, and a bandpass filter 10c passes the feedback IF signal in the center-frequency 100-MHz band and inputs this signal to the transmit-signal processor 21.

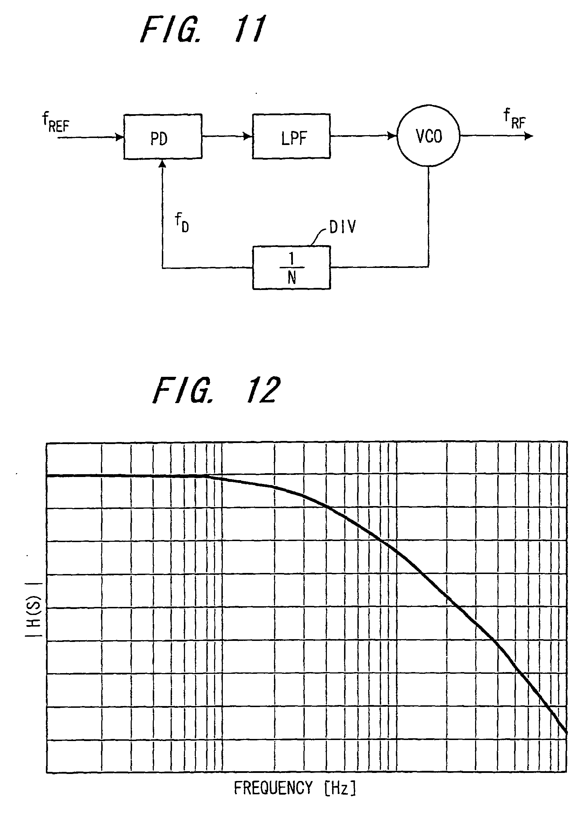

The local oscillators 5a, 5b, 10a have identical structures. Fig. 11 illustrates the structure of the local oscillators. The local oscillator includes a phase detector PD for outputting a voltage signal that conforms to the phase difference between a signal having a reference frequency $f_{REF}$ and a feedback signal having a frequency $f_D$; a low-pass filter LPF for smoothing a signal that is output from the phase detector; a voltage-controlled oscillator VCO for outputting a signal having a frequency $f_{RF}$ proportional to the output voltage of the low-pass filter; and a divider DIV for subjecting the signal of frequency $f_{RF}$ to 1/N frequency division. A transfer characteristic |H(s)| of this local oscillator is approximately the characteristic of a low-pass filter, as illustrated in Fig. 12. Phase noise is noise power of a 1-Hz band at the frequency of interest and is one factor that degrades signal quality. In a flat frequency interval up to the point where transfer characteristic |H(s)| falls by 3 dB, an amount PN of phase noise degradation can be expressed as follows:

$$PN = 20\log[f_{RF}/f_{REF}] \qquad (1)$$

Since the following holds:

$$f_{REF} = f_{RF}/N \qquad (2)$$

the amount of phase noise degradation is as follows:

$$PN = 20\log[N] \qquad (3)$$

In the conventional transmitting apparatus, the phase noise component of each local oscillation signal is impressed upon the transmit signal whenever there is a frequency conversion in the mixer. As a consequence, phase noise of the local oscillation signals of all local oscillators 5e, 5f, 10b are added to the feedback signal y(t) that enters the distortion compensation calculation unit 8c (Fig. 8). This phase noise is one factor that degrades signal quality. Such degradation of signal quality not only lowers the accuracy of calculation of the distortion compensation coefficients in the distortion compensation calculation unit 8c and impedes the generation of a normal distortion compensating component but also causes the occurrence of unwanted components. It will be appreciated from Equations (1) and (3) that the higher the oscillation frequency $f_{RF}$, the greater the influence of device performance and frequency multiplication N on the phase noise. Accordingly, with regard to influence upon signal quality, phase noise of the local oscillators 5f and 10b, which exhibit a high oscillation frequency, becomes predominant.

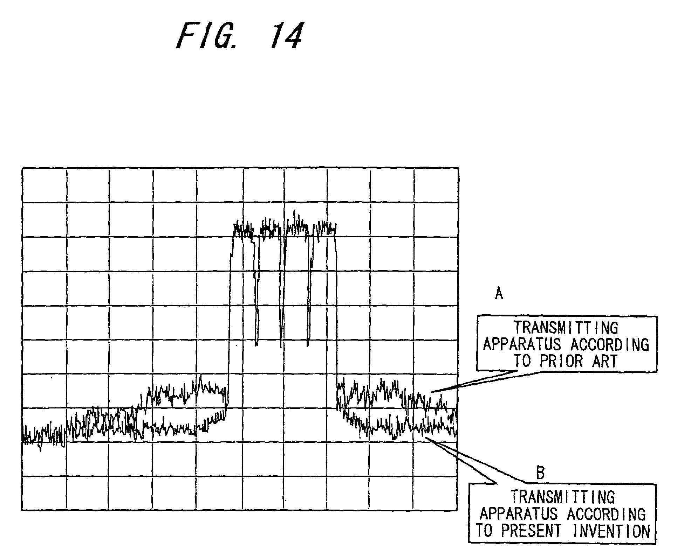

In Fig. 14, A denotes a transmit-signal spectrum under the influence of phase noise. Owing to a decline in quality of the feedback signal caused by phase noise, the calculation accuracy of the distortion compensation calculation unit 8c declines, unwanted components, namely components other than the distortion compensating component, are produced and leakage of power between adjacent channels increases.

Accordingly, an object of the present invention is to reduce signal degradation owing to phase noise and maintain the accuracy of calculation of the distortion compensation calculation unit to thereby reduce leakage of power between adjacent channels.

Disclosure of the Invention

In a transmitting apparatus having a distortion compensator that corrects distortion of an amplifier, a first frequency converter mixes local oscillation signals with a distortion-compensated transmit signal to thereby up-convert transmit-signal frequency to a radio frequency and input the resultant signal to the amplifier; a second frequency converter mixes local oscillation signals with an output signal of the amplifier to thereby down-convert a radio frequency to a prescribed frequency; and a local oscillation signal generator generates various local oscillation signals, synchronizes the phases of local oscillation signals of a high frequency used by the first and second frequency converters and makes the phase noise components thereof identical.

More specifically, a first frequency converter mixes a first local oscillation signal of low oscillation frequency with a distortion-compensated transmit signal and mixes a second local oscillation signal of high oscillation frequency with the result of mixing to thereby up-convert the transmit-signal frequency to a radio frequency. A second frequency converter mixes a third local oscillation signal of high oscillation frequency with the output of an amplifier and mixes a fourth local oscillation signal of low oscillation frequency with the result of mixing to thereby down-convert a radio frequency to a prescribed frequency. A local oscillation signal generator synchronizes the phases of the second and third local oscillation signals input to the first and second frequency converters and makes the noise signal components thereof identical. In order to synchronize the phases of the second and third local oscillation signals and make the phase noise components identical, the local oscillation signal generator inputs local oscillation signals, which are generated from a local oscillator having a high oscillation frequency, to the frequency converters as the second and third local oscillation signals.

Thus, by synchronizing the phases of the local oscillation signals of high frequency in the first and second frequency converters and making the phase noise components identical, phase noise ascribable to the local oscillation signals can be cancelled out and the quality of the feedback signal is improved. As a result, the leakage of power between adjacent channels can be reduced by distortion compensation.

Brief Description of the Drawings

Fig. 1 is a diagram useful in describing the principles of the present invention;
Fig. 2 illustrates the phase noise characteristics of a transmit IF signal, transmit RF signal and feedback IF signal;
Fig. 3 is diagram illustrating the structure of an embodiment of a transmitting apparatus according to the present invention;
Fig. 4 is a first structural diagram of a second embodiment;
Fig. 5 is a second structural diagram of a second embodiment;
Fig. 6 is a block diagram illustrating an example of a transmitting apparatus in a radio according to the prior art;
Fig. 7 is a diagram useful in describing the input/ output characteristic and frequency spectrum of an amplifier;
Fig. 8 is a block diagram of a transmitting apparatus equipped with a digital non-linear distortion compensating function;
Fig. 9 is a diagram showing the structure of a conventional transmitting apparatus that includes the details of structure of frequency converters;
Fig. 10 is a diagram useful in describing local oscillation frequencies;
Fig. 11 is a diagram showing the structure of a local oscillator;
Fig. 12 is a transfer characteristic |H(s)| of a local oscillator;
Fig. 13 is a phase noise characteristic; and
Fig. 14 shows transit-signal spectrums according to the prior art and the present invention.

Best Mode for Carrying Out the Invention

(A) Principles of the present invention

· Structure

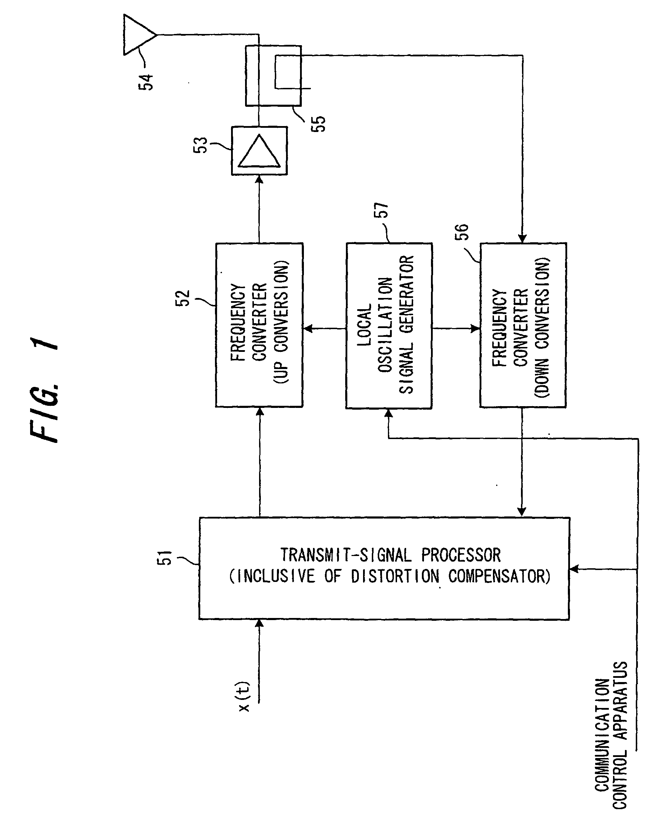

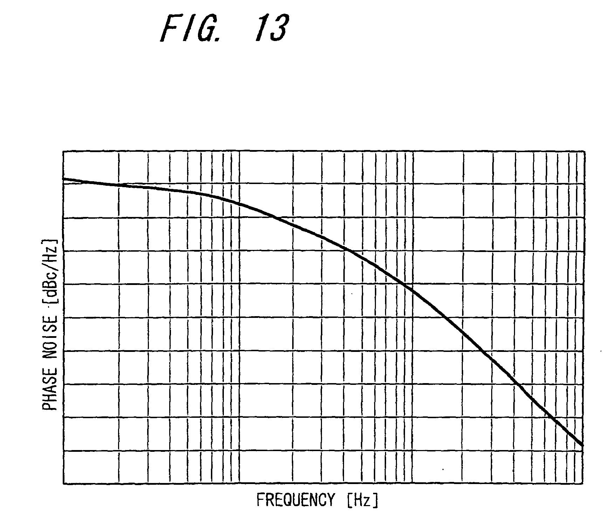

Fig. 1 is a diagram useful in describing the principles of the present invention. A transmit-signal processor 51, which has a structure identical with that of the transmit-signal processor shown in Fig. 8, includes the distortion compensator 8, digital modulator 4, DA converter 3, amplifier 11, AD converter 12 and digital demodulator 13. A first frequency converter 52 (transmit-frequency converter) 52 mixes local oscillation signals with a distortion-compensated transmit IF signal in the 60-MHz frequency band to thereby up-convert the frequency of the transmit IF signal to a radio frequency and input the resultant signal to a transmission power amplifier 53. The transmission power amplifier 53 amplifies the radio signal and radiates it into space from an antenna 54. A directional coupler 55 detects part of the output signal of the transmission power amplifier 53 and inputs it to a second frequency converter 56. The second frequency converter (feedback-frequency converter) 56 mixes local oscillation signals with the detected output of the transmission power amplifier, thereby down-converting the radio frequency to a frequency in the 100-MHz band and inputting the resultant signal to the transmit-signal processor 51. A local oscillation signal generator 57 generates local oscillation signals of various frequencies, synchronizes the phases of local oscillation signals of high frequencies used by the first and second frequency converters 52, 56 and makes the phase noise components thereof identical. The reason for synchronizing phases and making phase noise components identical only with regard to the local oscillation signals of high frequency is that the higher the frequency, the larger the phase noise component, as described in conjunction with Figs. 11 to 13, and it is this phase noise that is to be removed.

·Operation

The local oscillation signal generator 57 inputs local oscillation signals having synchronized phases and identical phase noise components to the first frequency converter 52 and second frequency converter 56. The first frequency converter 52 frequency-converts the transmit IF signal, which arrives from the distortion compensator and includes a distortion compensating component, to a transmit RF signal. At this time the transmit RF signal contains a phase noise component from the local oscillation signal in addition to the distortion compensating component. The transmit RF signal is amplified by the transmission power amplifier 53 and distortion produced by the transmission power amplifier 53 is compensated for by the distortion compensating component so that a transmit RF signal containing only the phase noise component is input to the directional coupler 55. The directional coupler 55 inputs the entered transmit RF signal to the antenna 54 as the transmit signal, extracts part of the transmit signal as the feedback RF signal and inputs this signal to the second frequency converter 56. The second frequency converter 56 frequency-converts the feedback RF signal to a feedback IF signal by local oscillation signals from the local oscillation signal generator 57. At this time a phase noise component contained in the feedback RF signal is cancelled out by the phase noise contained in the local oscillation signals and the resultant signal is input to the transmit-signal processor 51 as a feedback signal.

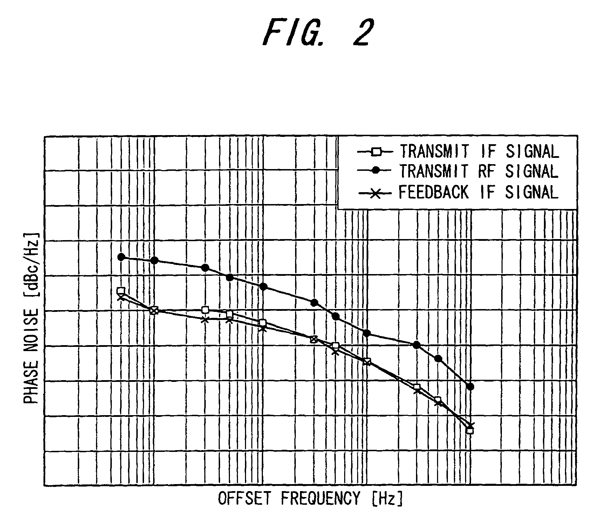

Fig. 2 illustrates the phase noise characteristics of a transmit IF signal, transmit RF signal and feedback IF signal. It will be understood that although the phase noise of the transmit RF signal worsens by 10 dB, the phase noise of the feedback IF signal takes on a phase noise characteristic equivalent to that of the transmit IF signal owing to cancellation of the phase noise of the local oscillation signals. Further, the spectrum of the transmit signal according to the present invention is illustrated at B in Fig. 14. As is evident from this spectrum characteristic, the quality of the feedback signal is improved, as a result of which the occurrence of unwanted components is suppressed and leakage of power between adjacent channels reduced.

(B) Embodiment of transmitting apparatus

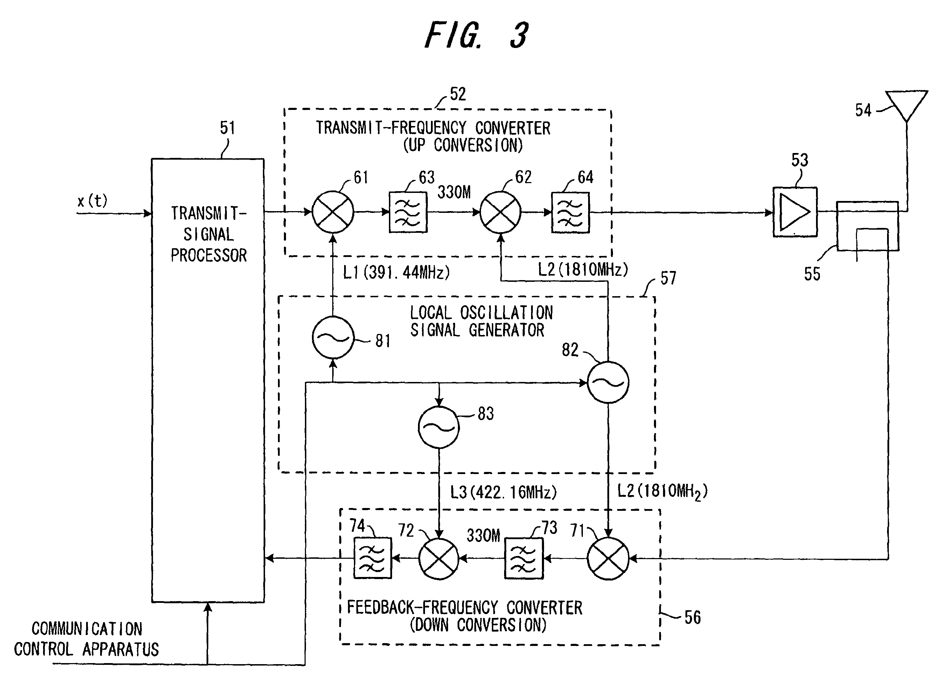

Fig. 3 is an embodiment of a transmitting apparatus according to the present invention, in which components identical with those of Fig. 1 are designated by like reference characters.

The transmit-frequency converter 52 has mixers 61, 62 cascade-connected in two stages. As illustrated at (B) in Fig. 10, the first mixer 61 mixes a local oscillation signal L1 in the 400-MHz band with a first transmit IF signal in the 60-MHz band output from the transmit-signal processor 51, and a bandpass filter 63 passes a second transmit IF signal in the center-frequency 300-MHz band. As illustrated at (C) in Fig. 10, the second mixer 62 mixes a local oscillation signal L2 in the 1800-MHz band with a second transmit IF signal that is output from the bandpass filter 63, and a bandpass filter 64 passes a radio signal in the center-frequency 2-GHz band and inputs this signal to the power amplifier 53.

The transmit-frequency converter 56 has mixers 71, 72 cascade-connected in two stages. The first mixer 71 mixes the local oscillation signal L2 in the 1800-MHz band with the output signal of the transmission power amplifier 53 detected by the directional coupler 55, and a bandpass filter 73 passes a first feedback IF signal in the center-frequency 300-MHz band. A second mixer 72 mixes a local oscillation signal L3 in the 400-MHz band with the first feedback IF signal that is output from the bandpass filter 73, and a bandpass filter 74 passes a second feedback IF signal in the center-frequency 100-MHz band and inputs this signal to the transmit-signal processor 51.

The local oscillation signal generator 57 has three local oscillators 81 to 83. The first local oscillator 81 generates the local oscillation signal L1 in the oscillation-frequency 400-MHz band and inputs this signal to the first transmit-frequency converter 52. The second local oscillator 82 generates the local oscillation signal L2 in the oscillation-frequency 1800-MHz band and inputs this signal to the second mixer 62 of the transmit-frequency converter 52 and to the first mixer 71 of the feedback-frequency converter 56. By inputting the local oscillation signal generated by one local oscillator to each of the frequency converters 52, 56, it is possible to achieve synchronization of the phases and to make the phase noise components identical. Further, the third local oscillator 83 generates the local oscillation signal L3 in the oscillation-frequency 400-MHz band and inputs this signal to the second mixer 72 of the feedback-frequency converter 56.

In view of the relationship among the oscillation frequencies, the phase noise of the second local oscillator 82 has the greatest influence on the degradation of signal quality. However, the influence upon the feedback signal is eliminated by the cancelling operation and the phase noise of the feedback IF signal becomes approximately the same as the phase noise of the transmit IF signal, as indicated in Fig. 2. The reason why the phase noise of the second local oscillator 82 is cancelled out is as follows: If we let $\sin\omega_1 t$ and $\cos(\omega_2 t+\phi)$ represent the transmit IF signal and local oscillation signal L2, respectively, that are input to the mixer 62, then the output of the second mixer 62 of transmit-frequency converter 52 will be

$$[\sin\{(\omega_1+\omega_2)t+\phi\} + \sin\{(\omega_1-\omega_2)t-\phi\}]/2$$

By passing the frequency component $(\omega_1+\omega_2)$ through the filter 64, $\sin\{(\omega_1+\omega_2)t+\phi\}$ is input to the amplifier 53 from the transmit-frequency converter 52.

The output of the first mixer 71 in the feedback-frequency converter 56 is

$$[\sin\{(\omega_1+2\omega_2)t+2\phi\} + \sin\omega_1 t]/2$$

By passing only the frequency component $\omega_1$ through the filter 73, only $\sin\omega_1 t$ enters the second mixer 72 and the local oscillation signal component $\cos(\omega_2 t+\phi)$ of the

second local oscillator 82 is eliminated. That is, by using the local oscillation signal $\cos(\omega_2 t+\phi)$, which is generated by the second local oscillator 82 having the high oscillation frequency, jointly in both the transmit-frequency converter 52 and feedback-frequency converter 56, the phase noise of the second local oscillator 82 is cancelled out and the influence upon the feedback signal can be eliminated.

(C) Second embodiment

In the first embodiment, mixers are cascade-connected in two stages in the transmit-frequency converter 52 and feedback-frequency converter 56. However, mixers can be cascade-connected in two stages in one of the frequency converters and a mixer of a single stage can be adopted for the other frequency converter.

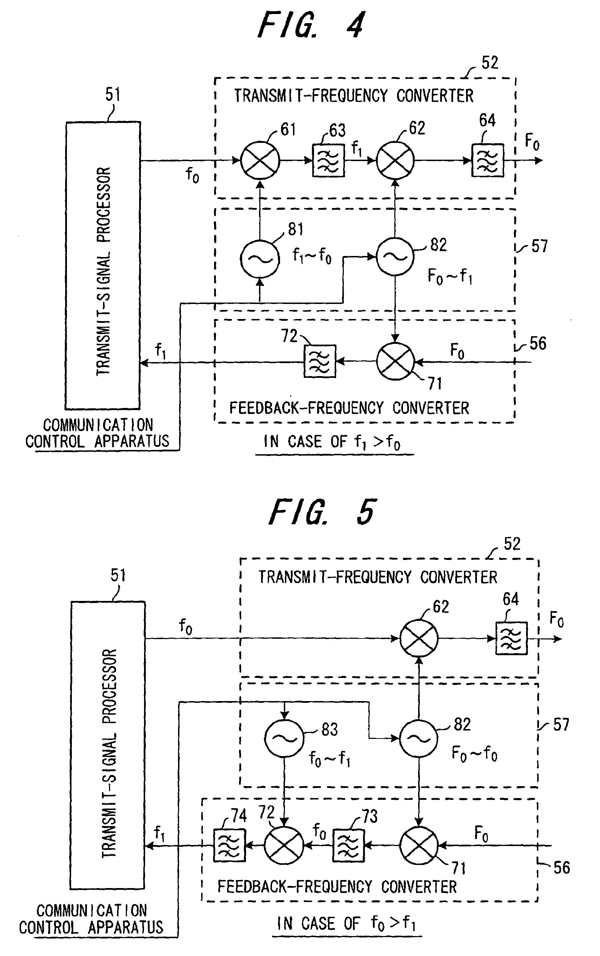

Fig. 4 illustrates an example in which the mixers 61, 62 are cascade-connected in two stages in the transmit-frequency converter 52 while the feedback-frequency converter 56 is provided with the mixer 71 of a single stage. This is a scheme that is effective in a case where the frequency $f_1$ of the feedback IF signal is high and, moreover, the frequency $f_1$ is considerably higher than the frequency $f_0$ of the transmit IF signal. It is assumed that $(f_1-f_0)$ is the oscillation frequency of the first local oscillator 81 and that $(F_0-f_1)$ is the oscillation frequency of the second local oscillator 82, where $F_0 = 2$ GHz holds.

Fig. 5 illustrates an example in which the transmit-frequency converter 52 is provided with the mixer 62 of a single stage while the mixers 71, 72 are cascade-connected in two stages in the feedback-frequency converter 56. This is a scheme that is effective in a case where the frequency $f_0$ of the transmit IF signal is high and, moreover, the frequency $f_1$ of the feedback IF signal is considerably lower than $f_0$. It is assumed that $(f_0-f_1)$ is the oscillation frequency of the third local oscillator 83 and that $(F_0-f_0)$ is the oscillation frequency of the second local oscillator 82, where $F_0 = 2$ GHz holds.

In accordance with the present invention, the phases of local oscillation signals of a high frequency used in a transmit-frequency converter and feedback-frequency converter are synchronized and the phase noise components thereof are made identical. As a result, phase noise of the local oscillation signals can be cancelled out, signal degradation due to phase noise can be mitigated and the calculation accuracy of a distortion compensation calculation unit can be maintained, thereby making it possible to reduce leakage of power between adjacent channels.

**Claims**

1. A transmitting apparatus having a distortion compensator that corrects distortion of an amplifier, **characterized by** comprising:

a first frequency converter for mixing local oscillation signals with a distortion-compensated transmit signal to thereby up-convert transmit-signal frequency to a radio frequency and input the resultant signal to said amplifier; a second frequency converter for mixing local oscillation signals with an output signal of said amplifier to thereby down-convert a radio frequency to a prescribed frequency and input the resultant signal to said distortion compensator; and a local oscillator signal generator for generating various local oscillation signals, synchronizing the phases of local oscillation signals of a high frequency used by the first and second frequency converters and making the phase noise components thereof identical.

2. A transmitting apparatus according to claim 1, **characterized in that** said local oscillation signal generator inputs a local oscillation signal of a high oscillation frequency to said first and second frequency converters in common.

3. A transmitting apparatus having a distortion compensator for updating a distortion compensation coefficient so as to null the difference between a transmit signal and a feedback signal and subjecting the transmit signal to distortion compensation processing using said distortion compensation coefficient to thereby compensate for distortion in an amplifier, an amplifier for amplifying the transmit signal that has undergone distortion compensation, and a feedback unit for feeding an output signal of said amplifier back to the distortion compensator, said apparatus **characterized by** comprising:

a first frequency converter for mixing a first local oscillation signal of a low oscillation frequency with said transmit signal that has undergone distortion compensation, and mixing a second local oscillation signal of a high oscillation frequency with result of mixing, thereby up-converting transmit-signal frequency to a radio frequency and inputting the resultant signal to said amplifier; a second frequency converter for mixing a third local oscillation signal of a high frequency with an output signal of the amplifier and mixing a fourth local oscillation signal of a low oscillation frequency with result of mixing, thereby down-converting a radio frequency to a prescribed frequency; and a local oscillation signal generator for generating each of said local oscillation signals,

wherein said local oscillation signal generator synchronizes the phases of the second and third local oscillation signals input to said first and second frequency converters and making phase noise components thereof identical.

4. A transmitting apparatus according to claim 3, **characterized in that** said local oscillation signal generator has a local oscillator of a high oscillation frequency, and local oscillation signals generated by said local oscillator are adopted as said second and third local oscillation signals.

5. A transmitting apparatus according to claim 4, **characterized in that** frequencies of said first and second local oscillation signals are made different from each other.

# FIG. 1

EP 1 505 738 A1

# FIG. 2

# FIG. 3

TRANSMIT-FREQUENCY CONVERTER
(UP CONVERSION) — 52

x(t) → TRANSMIT-SIGNAL PROCESSOR — 51

61  63  330M  62  64

53  54  55

L1(391.44MHz)  L2(1810MHz)

LOCAL OSCILLATION SIGNAL GENERATOR — 57

81  82  83  57

L3(422.16MHz)  L2(1810MH₂)

74  72  330M  73  71

FEEDBACK-FREQUENCY CONVERTER
(DOWN CONVERSION) — 56

COMMUNICATION CONTROL APPARATUS

EP 1 505 738 A1

# FIG. 4

TRANSMIT-SIGNAL PROCESSOR

COMMUNICATION CONTROL APPARATUS

51

TRANSMIT-FREQUENCY CONVERTER

52

$f_0$

61

63

$f_1$

62

64

$F_0$

81

$f_1 \sim f_0$

82

$F_0 \sim f_1$

57

72

71

$F_0$

56

$f_1$

FEEDBACK-FREQUENCY CONVERTER

IN CASE OF $f_1 > f_0$

# FIG. 5

TRANSMIT-SIGNAL PROCESSOR

COMMUNICATION CONTROL APPARATUS

51

TRANSMIT-FREQUENCY CONVERTER

52

$f_0$

62

64

$F_0$

83

$f_0 \sim f_1$

82

$F_0 \sim f_0$

57

74

72

$f_0$

73

71

$F_0$

56

$f_1$

FEEDBACK-FREQUENCY CONVERTER

IN CASE OF $f_0 > f_1$

## *FIG. 6*

```
[1] TRANSMIT-SIGNAL GENERATOR → [2] S/P → I/Q → [3] DA → I/Q → [4] QUADRATURE MODULATOR → [5] FC → [6] → [7]
TRANSMISSION POWER AMPLIFIER
REFERENCE CARRIER
```

## *FIG. 7*

(a)

OUTPUT POWER [dBm]

LINEAR REGION    NON-LINEAR REGION

INPUT POWER [dBm]

(b)

B    A    A'    B'

—— NO DISTORTION COMPENSATION
---- WITH DISTORTION COMPENSATION

f₀

## FIG. 8

TRANSMIT-SIGNAL PROCESSOR

1 TRANSMIT-SIGNAL GENERATOR

2 S/P

8 DISTORTION COMPENSATOR

4 DIGITAL QMOD

3 DAC

5 FREQUENCY CONVERTER

6

7

9

13 DIGITAL QDEM

12 ADC

11 AMPLIFIER

10 FREQUENCY CONVERTER

8

x(t)

8b PREDISTORTION UNIT

8a DISTORTION COMPENSATION COEFFICIENT MEMORY

8c DISTORTION COMPENSATION COEFFICIENT CALCULATION UNIT

y(t)

DISTORTION COMPENSATOR

13

# FIG. 9

# FIG. 10

(A)

Local
2078. 56M

2140M

ΔF
=61. 44M

(B)

330M

Local
391. 44M

ΔF
=61. 44M

(C)

1810M

2140M

ΔF=
330M

(D)

Local
2047. 84M

2140M

ΔF=
92. 16M

# FIG. 11

# FIG. 12

FREQUENCY [Hz]

# FIG. 13

*FIG. 14*

A

TRANSMITTING
APPARATUS ACCORDING
TO PRIOR ART

B

TRANSMITTING
APPARATUS ACCORDING
TO PRESENT INVENTION

EP 1 505 738 A1

## INTERNATIONAL SEARCH REPORT

International application No.

PCT/JP02/06085

| A. CLASSIFICATION OF SUBJECT MATTER |
| :--- |
| Int.Cl⁷ H04B1/04, H03F1/32 |

According to International Patent Classification (IPC) or to both national classification and IPC

| B. FIELDS SEARCHED |
| :--- |

Minimum documentation searched (classification system followed by classification symbols)
Int.Cl⁷ H04B1/04, H03F1/32

Documentation searched other than minimum documentation to the extent that such documents are included in the fields searched

| Jitsuyo Shinan Koho | 1922-1996 | Toroku Jitsuyo Shinan Koho | 1994-2002 |
| Kokai Jitsuyo Shinan Koho | 1971-2002 | Jitsuyo Shinan Toroku Koho | 1996-2002 |

Electronic data base consulted during the international search (name of data base and, where practicable, search terms used)

| C. DOCUMENTS CONSIDERED TO BE RELEVANT | | |
| :--- | :--- | :--- |
| Category* | Citation of document, with indication, where appropriate, of the relevant passages | Relevant to claim No. |
| E,X | JP 2002-176321 A (Matsushita Electric Industrial Co., Ltd.), 21 June, 2002 (21.06.02), Fig. 1 (Family: none) | 1-5 |
| X | JP 2002-77284 A (Hitachi Kokusai Electric Inc.), 15 March, 2002 (15.03.02), Fig. 1 (Family: none) | 1-5 |
| X | JP 2001-102941 A (Hitachi Denshi, Ltd.), 13 April, 2001 (13.04.01), Fig. 1 (Family: none) | 1-5 |

☒ Further documents are listed in the continuation of Box C. ☐ See patent family annex.

| * Special categories of cited documents: | "T" later document published after the international filing date or priority date and not in conflict with the application but cited to understand the principle or theory underlying the invention |
| :--- | :--- |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| :--- | :--- |
| 06 August, 2002 (06.08.02) | 20 August, 2002 (20.08.02) |

| Name and mailing address of the ISA/ | Authorized officer |
| :--- | :--- |
| Japanese Patent Office | |
| Facsimile No. | Telephone No. |

Form PCT/ISA/210 (second sheet) (July 1998)

**INTERNATIONAL SEARCH REPORT**

International application No.

PCT/JP02/06085

| C (Continuation). DOCUMENTS CONSIDERED TO BE RELEVANT | | |
|---|---|---|
| Category* | Citation of document, with indication, where appropriate, of the relevant passages | Relevant to claim No. |
| X | JP 2000-92145 A (NEC Corp.),<br>31 March, 2000 (31.03.00),<br>Fig. 2<br>(Family: none) | 1-5 |
| X | JP 2000-13254 A (Hitachi Denshi, Ltd.),<br>14 January, 2000 (14.01.00),<br>Fig. 1<br>(Family: none) | 1-5 |

Form PCT/ISA/210 (continuation of second sheet) (July 1998)